# EUROPEAN PATENT SPECIFICATION

(11) **EP 4 051 499 B1**
(45) Date of publication and mention of the grant of the patent: **07.05.2025**
(21) Application number: 20792663.5
(22) Date of filing: 20.10.2020
(51) Int. Cl.: B41C 1/10, G03F 7/027, C08L 51/00, G03F 7/033, G03F 7/09, C08F 220/14, C08F 265/06, C08F 285/00, C09D 4/06

(54) **A LITHOGRAPHIC PRINTING PLATE PRECURSOR AND METHOD FOR MAKING HYDROPHOBIC RESIN PARTICLES**
LITHOGRAPHIEDRUCKPLATTENVORLÄUFER UND VERFAHREN ZUR HERSTELLUNG VON HYDROPHOBEN HARZPARTIKELN
PRÉCURSEUR DE PLAQUE D'IMPRESSION LITHOGRAPHIQUE ET PROCÉDÉ DE FABRICATION DE PARTICULES DE RÉSINE HYDROPHOBE

(30) Priority: 31.10.2019 EP 19206525
(43) Date of publication of application: 07.09.2022
(73) Proprietor: ECO3 BV, 2640 Mortsel (BE)
(72) Inventor: BILLIET, Thomas, 2640 Mortsel (BE); VAN AERT, Hubertus, 2640 Mortsel (BE); LEENDERS, Janus, 2640 Mortsel (BE); HEYLEN, Kristof, 2640 Mortsel (BE)
(74) Representative: De Clercq & Partners
(86) International application number: PCT/EP2020/079452
(87) International publication number: WO 2021/083729

(56) References cited:
- EP-A1- 0 520 478
- EP-A1- 0 685 501
- EP-A1- 3 409 499
- CN-B- 105 199 050
- JP-A- H01 108 209
- JP-A- H01 318 027
- JP-A- S6 264 814
- US-A- 3 144 420
- US-A1- 2005 003 285
- US-A1- 2017 183 440
- XIE HONG-QUAN ET AL: "Copolymerization of Polymethyl Methacrylate Macromers with n -Butyl Acrylate and Mechanical Properties of the Graft Copolymers", JOURNAL OF MACROMOLECULAR SCIENCE : PART A - CHEMISTRY., vol. 27, no. 4, 1 April 1990 (1990-04-01), US, pages 491 - 507, XP055799286, ISSN: 0022-233X, Retrieved from the Internet <URL:http://dx.doi.org/10.1080/00222339009349571> DOI: 10.1080/00222339009349571
- ISHIZU KOJI ET AL: "Synthesis of star polymers by organized polymerization of macromonomers", POLYMER, vol. 36, no. 21, 1995, pages 4155 - 4157, XP028821122, ISSN: 0032-3861, DOI: 10.1016/0032-3861(95)91000-W

## Description

### Technical Field

The invention relates to a novel lithographic printing plate precursor.

### Background Art

Lithographic printing typically involves the use of a so-called printing master such as a printing plate which is mounted on a cylinder of a rotary printing press. The master carries a lithographic image on its surface and a print is obtained by applying ink to said image and then transferring the ink from the master onto a receiver material, which is typically paper. In conventional lithographic printing, ink as well as an aqueous fountain solution (also called dampening liquid) are supplied to the lithographic image which consists of oleophilic (or hydrophobic, i.e. ink-accepting, water-repelling) areas as well as hydrophilic (or oleophobic, i.e. water-accepting, ink-repelling) areas. In so-called driographic printing, the lithographic image consists of ink-accepting and ink-abhesive (ink-repelling) areas and during driographic printing, only ink is supplied to the master.

Lithographic printing masters are generally obtained by the image-wise exposure and processing of a radiation sensitive layer on a lithographic support. Imaging and processing renders the so-called lithographic printing plate precursor into a printing plate or master. Image-wise exposure of the radiation sensitive coating to heat or light, typically by means of a digitally modulated exposure device such as a laser, triggers a physical and/or chemical process, such as ablation, polymerization, insolubilization by cross-linking of a polymer or by particle coagulation of a thermoplastic polymer latex, solubilization by the destruction of intermolecular interactions or by increasing the penetrability of a development barrier layer. Although some plate precursors are capable of producing a lithographic image immediately after exposure, the most popular lithographic plate precursors require wet processing since the exposure produces a difference in solubility or difference in rate of dissolution in a developer between the exposed and the non-exposed areas of the coating. In positive working lithographic plate precursors, the exposed areas of the coating dissolve in the developer while the non-exposed areas remain resistant to the developer. In negative working lithographic plate precursors, the non-exposed areas of the coating dissolve in the developer while the exposed areas remain resistant to the developer. Most lithographic plate precursors contain a hydrophobic coating on a hydrophilic support, so that the areas which remain resistant to the developer define the ink-accepting, hence printing areas of the plate while the hydrophilic support is revealed by the dissolution of the coating in the developer at the non-printing areas.

Photopolymer printing plates rely on a working-mechanism whereby the coating - which typically includes free radically polymerisable compounds - hardens upon exposure. "Hardens" means that the coating becomes insoluble or non-dispersible in the developing solution and may be achieved through polymerization and/or crosslinking of the photosensitive coating upon exposure to light and/or heat. Photopolymer plate precursors can be sensitized to blue, green or red light i.e. wavelengths ranging between 450 and 750 nm, to violet light i.e. wavelengths ranging between 300 and 450 nm or to infrared light i.e. wavelengths ranging between 750 and 1500 nm. Optionally, the exposure step is followed by a heating step to enhance or to speed-up the polymerization and/or crosslinking reaction.

In general, a toplayer or protective overcoat layer over the imageable layer is required to act as an oxygen barrier to provide the desired sensitivity to the plate. A toplayer typically includes water-soluble or water-swellable polymers such as for example polyvinyl alcohol. Besides acting as barrier for oxygen, the toplayer should best be easily removable during processing and be sufficiently transparent for actinic radiation, e.g. from 300 to 450 nm or from 450 to 750 nm or from 750 to 1500 nm.

The classical workflow of photopolymer plates involves first an exposure step of the photopolymer printing plate precursor in a violet or infrared platesetter, followed by an optional pre-heat step, a wash step of the protective overcoat layer, an alkaline developing step, and a rinse and gum step. However, there is a clear evolution in the direction of a simplified workflow where the pre-heat step and/or wash step are eliminated and where the processing and gumming step are carried out in one single step or where processing is carried out with a neutral gum and then gummed in a second step. Alternatively, on-press processing wherein the plate is mounted on the press and the coating layer is developed by interaction with the fountain and/or ink that are supplied to the plate during the press run, has become very popular. During the first runs of the press, the non-image areas are removed from the support and thereby define the non-printing areas of the plate.

However, lithographic printing plate precursors which are processed on-press with fountain and ink, often show a poor cleanout behaviour and/or an insufficient roll-up performance. Indeed, such processing under non-aggressive conditions - i.e. without application of for example alkaline solutions - may result in incomplete removal of the coating in the non-exposed areas (i.e. insufficient clean-out) leading to an increased tendency of accepting ink (i.e. toning) at these areas. Insufficient roll-up performance on the other hand means that the ink acceptance at the image areas is too weak during the start-up of the printing process. This too low take-up of ink results in a too low optical density at the printing areas on the first number of printed sheets. It is desirable that the number of these "unusable" printed sheets is as low as possible in order to reduce the waste of paper in the start-up of the printing process. Indeed, at the start of a printing process, the printing plate is fed with fountain solution and ink. The non-image areas are hydrophilic and accept the fountain solution while the image areas are hydrophobic and accept ink. However, often the printing areas are not sufficiently hydrophobic at the start of the printing process due to for example the presence of hydrophilic ingredients remaining on these areas and will accept ink in a lower amount than expected. This results in printed sheets with a poor visual image contrast and are unusable for the customer. When more sheets are printed, the ink acceptance in the printing areas increases, and the visual image contrast on the printed sheets improves and, finally, after printing a number of sheets, it becomes acceptable for the customer. It is desirable that the number of these "unusable" printed sheets is as low as possible in order to reduce the waste of paper in the start-up of the printing process.

To solve this problem, polymers having hydrophilic groups which should, based on their high solubility in water, ensure a fast clean-out in an on-press processing, have been proposed in the literature. Examples thereof include graft copolymers having hydrophilic segments, block and graft copolymers having polyethylene oxide (PEO) segments, polymers having both pendant poly(alkylene oxide) segments and pendant cyano groups in the recurring units forming the polymer backbone, and various hydrophilic polymeric binders that may include hydrophilic groups such as for example a hydroxyl, carboxy, hydroxyethyl, hydroxypropyl, amino, aminoethyl, aminopropyl, carboxymethyl or sulfonyl group.

US 2005/0003285 discloses that for on-press developable negative-working lithographic printing plate precursors, the use of polymeric binders comprising pendant polyalkylenes oxide segments provide an improved solvent resistance and run length to the printing plates.

US 6,899,994 discloses that using binders in particulate form over using non-particulate binders tends to promote the developability of the unexposed non image areas combined with an enhanced durability of the exposed image areas.

Particulate polymeric binders generally include polymeric emulsions or dispersions of polymers which have a hydrophobic backbone and pendant poly(alkylene oxide) side chains, such polymers are described in for example US 6,582,882; EP 2 363 748; US 7,005,234; US 7,368,215 and US 2003/0064318.

However, as such hydrophilic binders are typically soluble and/or dispersable in fountain solutions used during the on press development, accumulation of such binder materials in the fountain solution may lead to pollution of the fountain solution and/or deposits or fouling of the printing press. Moreover, such a contamination of the fountain solution may alter the ink-water balance during printing leading to printing failures such as image "blinding" (ink fails to attach to the image areas) or "scumming" (ink attaches to the non-image areas), or both.

In conclusion, in order to expand the applicability of on-press developable printing plates there is an urgent need to further improve the clean out behaviour and/or roll up performance while minimizing, or even preventing, contamination of the fountain solution during on press processing.

### Summary of invention

It is an object of the present invention to provide a lithographic printing plate precursor which, upon image-wise exposure and processing on-press with fountain solution and/or ink, exhibits both an improved clean out and roll-up performance during the start-up of the printing process and minimizes contamination of the fountain solution.

This object is realised by the printing plate precursor defined in claim 1 with preferred embodiments defined in the dependent claims. The printing plate precursor of the present invention has the specific feature that it contains a coating comprising a polymerisable compound, optionally a sensitizer, a photoinitiator and discrete particles which comprise a crosslinked hydrophobic polymer backbone and a plurality of pendant hydrophobic grafts.

According to the current invention, it was surprisingly found that by incorporating these discrete particles in the coating, the clean out and rollup performance is significantly improved. As a result, the printing plate of the present invention has the advantage that a faster start-up on the press is obtained. Under "clean-out" is understood the removal of the coating in the non-exposed areas, revealing the hydrophilic surface of the support. The roll-up is defined as the number of sheets necessary to achieve a visual image contrast acceptable for the customer. This typically means that the optical density in the printing areas is at least 80% of the final optical density.

During the on-press processing step the plate precursor is mounted on the plate cylinder of the printing press and the non-exposed areas of the coating are removed by rotating the plate cylinder while feeding dampening liquid and/or ink to the coating. It is believed that the solubility of the coating including particles having hydrophobic grafts in the oily ink used during the on-press processing step, is significantly improved. As a result, the aqueous fountain solution becomes less contaminated while the dissolved non-exposed areas of the coating in the oily ink are eliminated on the printed sheets during the first rotations of the printing press.

It is a further object of the present invention to provide a method for making a lithographic printing plate comprising the steps of:
- image-wise exposing the printing plate precursor including the coating as defined above to heat and/or IR radiation whereby a lithographic image consisting of image areas and non-image areas is formed;
- developing the exposed precursor.

Other features, elements, steps, characteristics and advantages of the present invention will become more apparent from the following detailed description of preferred embodiments of the present invention. Specific embodiments of the invention are also defined in the dependent claims.

### Description of embodiments

### The lithographic printing plate precursor

The lithographic printing plate precursor according to the present invention is negative-working, i.e. after exposure and development the non-exposed areas of the coating are removed from the support and define hydrophilic (non-printing) areas, whereas the exposed coating is not removed from the support and defines oleophilic (printing) areas. The hydrophilic areas are defined by the support which has a hydrophilic surface or is provided with a hydrophilic layer. The hydrophobic areas are defined by the coating, hardened upon exposing, optionally followed by a heating step. Areas having hydrophilic properties means areas having a higher affinity for an aqueous solution than for an oleophilic ink; areas having hydrophobic properties means areas having a higher affinity for an oleophilic ink than for an aqueous solution.

"Hardened" means that the coating becomes insoluble or non-dispersible for the developing solution and may be achieved through polymerization and/or crosslinking of the photosensitive coating, optionally followed by a heating step to enhance or to speed-up the polymerization and/or crosslinking reaction. In this optional heating step, hereinafter also referred to as "pre-heat", the plate precursor is heated, preferably at a temperature of about 80°C to 150°C and preferably during a dwell time of about 5 seconds to 1 minute.

The coating of the printing plate precursor is most preferably capable of being developed on-press with dampening liquid and/or ink.

### Toplayer

The coating preferably includes a toplayer or protective overcoat layer which preferably acts as an oxygen barrier layer. Low molecular weight substances present in the air may deteriorate or even inhibit image formation and therefore a toplayer is applied to the coating. A toplayer should preferably be easily removable during development, adhere sufficiently to the photopolymerisable layer or optional other layers of the coating and should preferably not inhibit the transmission of light during exposure. The toplayer is provided on top of the photopolymerisable layer.

The toplayer preferably includes an infrared absorbing compound which is capable of forming a coloured compound - whereby a print-out image is formed - upon exposure to infrared light and/or heat. The infrared absorbing compound is preferably an infrared absorbing dye, also referred to as IR dye. The contrast of the print-out image may be defined as the difference between the optical density at the exposed area and the optical density at the non-exposed area, and is preferably as high as possible. This enables the end-user to establish immediately whether or not the precursor has already been exposed and processed, to distinguish the different color selections and to inspect the quality of the image on the plate precursor. More information regarding such IR dyes can be found in in EP 1 910 082 pages 4 to 8, IRD-001 to IRD-101.

The toplayer may further include a binder. Preferred binders which can be used in the toplayer are polyvinyl alcohol. The polyvinylalcohol has preferably a hydrolysis degree ranging between 74 mol % and 99 mol %, more preferably between 80-98%. The weight average molecular weight of the polyvinylalcohol can be measured by the viscosity of an aqueous solution, 4 % by weight, at 20°C as defined in DIN 53 015, and this viscosity number ranges preferably between 2 and 30, more preferably between 2 and 15, most preferably between 2 and 10.

The toplayer preferably includes a hydrophobic binder including a monomeric unit derived from a vinyl monomer and/or a vinylidene monomer which comprises a halogen such as chloride or fluoride as described in unpublished patent application EP18178933.

The overcoat layer may optionally include other ingredients such as inorganic or organic acids, matting agents, surfactants, (organic) waxes or wetting agents as disclosed in EP 2 916 171.

The coating thickness of the toplayer is between 0.10 and 1.75 g/m², more preferably between 0.20 and 1.3 g/m², most preferably between 0.25 and 1.0 g/m². In a more preferred embodiment of the present invention, the toplayer has a coating thickness between 0.25 and 1.75 g/m² and comprises a polyvinylalcohol having a hydrolysis degree ranging between 74 mol % and 99 mol % and a viscosity number as defined above ranging between 3 and 30.

The hydrophilic polymers in the protective overcoat layer may result in a problematic viscosity increase of press chemicals such as for example fountain solution and/or developer solution. Therefore, the thickness of the protective overcoat layer should preferably not be too high e.g. above the ranges as given above.

### Support

The lithographic printing plate used in the present invention comprises a support which has a hydrophilic surface or which is provided with a hydrophilic layer. The support is preferably a grained and anodized aluminium support, well known in the art. Suitable supports are for example disclosed in EP 1 843 203 (paragraphs [0066] to [0075]). The surface roughness, obtained after the graining step, is often expressed as arithmetical mean center-line roughness Ra (ISO 4287/1 or DIN 4762) and may vary between 0.05 and 1.5 µm. The aluminum substrate of the current invention has preferably an Ra value between 0.1 and 1.4 µm, more preferably between 0.3 and 1.0 µm and most preferably between 0.4 and 0.9 µm. The lower limit of the Ra value is preferably about 0.1 µm. More details concerning the preferred Ra values of the surface of the grained and anodized aluminum support are described in EP 1 356 926. By anodising the aluminum support, an Al₂O₃ layer is formed and the anodic weight (g/m² Al₂O₃ formed on the aluminum surface) varies between 1 and 8 g/m². The anodic weight is preferably ≥ 2.0 g/m², more preferably ≥ 2.5 g/m² and most preferably ≥ 3.0 g/m²

The grained and anodized aluminium support may be subjected to so-called post-anodic treatments, for example a treatment with polyvinylphosphonic acid or derivatives thereof, a treatment with polyacrylic acid or derivatives thereof, a treatment with potassium fluorozirconate or a phosphate, a treatment with an alkali metal silicate, or combinations thereof. Enlargement or sealing of micropores of the amodized aluminum as disclosed in JP2001-253181A or JP2001-322365A may be performed. Alternatively, the support may be treated with an adhesion promoting compound such as those described in EP 1 788 434 in [0010] and in WO 2013/182328. However, for a precursor optimized to be used without a pre-heat step it is preferred to use a grained and anodized aluminium support without any post-anodic treatment.

Besides an aluminium support, a plastic support, for example a polyester support, provided with one or more hydrophilic layers as disclosed in for example EP 1 025 992 may also be used.

### Photopolymer coating

### Photopolymerisable compound

The coating has at least one layer including a photopolymerisable composition, said layer is also referred to as the "photopolymerisable layer". The coating may include an intermediate layer, located between the support and the photopolymerisable layer.

The photopolymerisable layer includes at least one polymerisable compound, an initiator, optionally a sensitizer and optionally a binder. The photopolymerisable layer has a coating thickness preferably ranging between 0.2 and 5.0 g/m², more preferably between 0.4 and 3.0 g/m², most preferably between 0.6 and 2.2 g/m².

According to a preferred embodiment of the present invention, the polymerisable compound is a polymerisable monomer or oligomer including at least one terminal ethylenic unsaturated group, hereinafter also referred to as "free-radical polymerisable monomer". The polymerisation involves the linking together of the free-radical polymerisable monomers. Suitable free-radical polymerisable monomers include, for example, multifunctional (meth)acrylate monomers (such as (meth)acrylate esters of ethylene glycol, trimethylolpropane, pentaerythritol, ethylene glycol, ethoxylated trimethylolpropane, urethane (meth)acrylate) and oligomeric amine di(meth)acrylates. The (meth)acrylic monomers may also have other ethylenically unsaturated groups or epoxide groups in addition to the (meth)acrylate group. The (meth)acrylate monomers may also contain an acidic (such as a carboxylic acid or phosphoric acid) or basic (such as an amine) functionality.

Suitable free-radical polymerisable monomers are disclosed in [0042] and [0050] of EP 2 916 171.

### The initiator

Any free radical initiator capable of generating free radicals upon exposure directly or in the presence of a sensitizer, is according to this invention a suitable initiator. Suitable examples of initiators include onium salts, carbon-halogen bond-containing compounds such as [1,3,5] triazines having trihalomethyl groups, organic peroxides, aromatic ketones, thio compounds, azo based polymerization initiators, azide compounds, ketooxime esters, hexaarylbisimidazoles, metallocenes, active ester compounds, borates and quinonediazides. Of these, onium salts, especially iodonium and/or sulfonium salts are preferable in view of storage stability.

More specific suitable free-radical initiators include, for example, the derivatives of acetophenone (such as 2,2-dimethoxy-2-phenylacetophenone, and 2-methyl-I-[4-(methylthio) phenyll-2-morpholino propan-I-one); benzophenone; benzil; ketocoumarin (such as 3-benzoyl-7-methoxy coumarin and 7-methoxy coumarin); xanthone; thioxanthone; benzoin or an alkyl-substituted anthraquinone; onium salts (such as diaryliodonium hexafluoroantimonate, diaryliodonium triflate, (4-(2-hydroxytetradecyl-oxy)-phenyl) phenyliodonium hexafluoroantimonate, triarylsulfonium hexafluorophosphate, triarylsulfonium p-toluenesulfonate, (3-phenylpropan-2-onyl) triaryl phosphonium hexafluoroantimonate, and N-ethoxy(2-methyl)pyridinium hexafluorophosphate, and onium salts as described in U.S. Pat.Nos. 5,955,238,6,037,098, and 5,629,354); borate salts (such as tetrabutylammonium triphenyl(n-butyl)borate, tetraethylammonium triphenyl(n-butyl)borate, diphenyliodonium tetraphenylborate, diphenyliodonium tetraphenylborate wherein the phenyl groups of the iodonium salt are substituted with a group including at least six carbon atoms, and triphenylsulfonium triphenyl(n-butyl)borate, and borate salts as described in U.S. Pat. Nos. 6,232,038 and 6,218,076,); haloalkyl substituted s-triazines (such as 2,4-bis(trichloromethyl)-6-(p-methoxy-styryl)-s-triazine, 2,4-bis(trichloromethyl)-6-(4-methoxy-naphth-I-yl)-s-triazine, 2,4-bis(trichloromethyl)-6-piperonyl-s- triazine, and 2,4-bis(trichloromethyl)-6-[(4 -ethoxy-ethylenoxy)-phen-1-yl]-s-triazine, and s-triazines as described in U.S. Pat. Nos. 5,955,238, 6,037,098, 6,010,824 and 5,629,354); and titanocene (bis(etha.9-2,4-cyclopentadien-1-yl) bis[2,6-difluoro-3-(IH-pyrrol-1-yl)phenyl) titanium). Onium salts, borate salts, and s-triazines are preferred free radical initiators. Diaryliodonium salts and triarylsulfonium salts are preferred onium salts. Triarylalkylborate salts are preferred borate salts. Trichloromethyl substituted s-triazines are preferred s-triazines. These initiators may be used alone or in combination.

Optionally substituted trihaloalkyl sulfones wherein halo independently represents bromo, chloro or iodo and sulfone is a chemical compound containing a sulfonyl functional group attached to two carbon atoms, are particularly preferred initiators. Tribromomethyl phenyl sulfones are most preferred initiators. More details concerning this initiator can be found in unpublished copending application EP 18163285.2 paragraphs [0029] to [0040].

The amount of the initiator typically ranges from 0.1 to 30 % by weight, preferably from 0.5 to 15 % by weight, most preferably from 2 to 10 % by weight relative to the total dry weight of the components of the photopolymerisable composition.

The photopolymerisable layer may also comprise a co-initiator. Typically, a co-initiator is used in combination with a free radical initiator. Suitable co-initiators for use in the photopolymer coating are disclosed in US 6,410,205; US 5,049,479; EP 1 079 276, EP 1 369 232, EP 1 369 231, EP 1 341 040, US 2003/0124460, EP 1 241 002, EP 1 288 720 and in the reference book including the cited refences: Chemistry & Technology UV & EB formulation for coatings, inks & paints - Volume 3 -Photoinitiators for Free Radical and Cationic Polymerisation by K.K. Dietliker - Edited by P.K.T. Oldring - 1991 - ISBN 0 947798161. Specific co-initiators, as described in EP 107 792, may be present in the photopolymerizable layer to further increase the sensitivity. Preferred co-initiators are disclosed in EP 2 916 171 [0051].

Specific co-initiators, as described in EP 107 792, may be present in the photopolymerizable layer to further increase the sensitivity. Preferred co-initiators are sulfur-compounds, especially thiols like e.g. 2-mercaptobenzothiazole, 2-mercaptobenzoxazole, 2-mercaptobenzimidazole, 4-methyl-3-propyl-1,2,4-triazoline-5-thione, 4-methyl-3-n-heptyl-1,2,4-triazoline-5-thione, 4-phenyl-3-n-heptyl-1,2,4-triazoline-5-thione, 4-phenyl-3,5-dimercapto-1,2,4-triazole, 4-n-decyl-3,5-dimercapto-1,2,4-triazole, 5-phenyl-2-mercapto-1,3,4-oxadiazole, 5-methylthio-1,3,4-thiadiazoline-2-thione, 5-hexylthio-1,3,4-thiadiazoline-2-thione, mercaptophenyltetrazole, pentaerythritol mercaptopropionate, butyric acid-3-mercapto-neopentanetetrayl ester, pentaerythritol tetra(thioglycolate). Other preferred co-initiators are polythioles as disclosed in WO 2006/048443 and WO 2006/048445. These polythiols may be used in combination with the above described thiols, e.g. 2-mercaptobenzothiazole.

### Sensitizer

The photopolymerisable layer preferably includes a sensitizer which is capable of absorbing light used in the image-wise exposing step. A sensitizer which absorbs light between 750 nm and 1300 nm, preferably between 780 nm and 1200 nm, more preferably between 800 nm and 1100 nm may be used. Particular preferred sensitizers are heptamethinecyanine dyes such as for example disclosed in EP 1 359 008. Other preferred sensitizers are violet light absorbing sensitizers having an absorption spectrum between 350 nm and 450 nm such as disclosed in EP 1 349 006 paragraph [0007] to [0009], EP 1 668 417 and WO 2004/047930. Other preferred sensitizers are or blue, green or red light absorbing sensitizers, having an absorption spectrum between 450 nm and 750 nm. Useful sensitizers can be selected from the sensitizing dyes disclosed in US 6,410,205; US 5,049,479; EP 1 079 276, EP 1 369 232, EP 1 349 006, EP 1 668 417, WO 2004/047930, EP 1 369 231, EP 1 341 040, US 2003/0124460, EP 1 241 002 and EP 1 288 720. Optionally, an optical brightener may be added to the coating. Suitable examples thereof are described in WO 2005/109103 page 24, line 20 to page 39.

### The binder

The lithographic printing plate precursor of the present invention includes one or more polymeric binders or (co)polymers that preferably facilitate the developability of the coating. At least one of such polymeric binders is present, at least partially, as discrete particles.

The discrete particles - also referred to herein as "particulate resin binder or particulate binder" - comprise a crosslinked hydrophobic polymer backbone and a plurality of pendant hydrophobic grafts linked to this backbone. The hydrophobic grafts may be directly attached to the polymer backbone with a carbon/carbon bond or through a linking group. The resin particles are preferably distributed, preferably uniformly, throughout the imageable layer.

The resin particles preferably exist at room temperature as discrete particles, for example in an aqueous dispersion or emulsion. Such particulate resin binders generally have a weight average molecular weight (Mw) of at least 5,000 and typically at least 20,000 and up to and including 10,000,000, or of at least 30,000 and up to and including 300,000, as determined by Gel Permeation Chromatography whereby the molecular weights are correlated to polystyrene standards. The resin particles are preferably uniformly distributed within the photosensitive layer.

Preferably, these discrete particles are non-agglomerated and have a particle size of at least 10 nm and up to and including 1000, more preferably a particle size of at least 20 nm and up to and including 500 nm, most preferably a particle size of at least 25 nm and up to and including 250 nm. The size of the particles is preferable adjusted to the coating thickness, i.e. the particles preferably have a diameter which is smaller than the thickness of the coating. The coating has preferably a layer thickness comprised between 0.5 µm and 2.0 µm, more preferably between 0.8 and 1.2 micron. The particle size refers to the z-average particle size and may be measured - as described in the Examples - by a laser diffraction particle analyzer such as Malvern Zetasizer Nano S.

### The hydrophobic polymer backbone

The hydrophobic polymer backbone is crosslinked and contains repeating units preferably derived from the monomers selected from alkyl(meth)acrylates such as for example methylmethacrylate, ethyl methacrylate, methylacrylate or ethylacrylate; styrene; (meth)acrylatestyrene, vinylchlorides, vinyl esters, vinyl ethers, vinylidene chlorides and/or vinylidene fluorides, and/or combinations thereof, and/or repeating units comprising a segment including ethers, esters, amides, ketones, carbonates, olefines such as ethylene or propylene, halogenated olefines such as fluorinated olefins for example tetrafluoroethylene and chlorotrifluoro ethylene, imides, urethanes and/or a polyurea and/or combinations thereof.

More preferably, the hydrophobic polymer backbone contains repeating units selected from alkyl(meth)acrylates such as for example methylmethacrylate, ethylmethacrylate, methylacrylate or ethylacrylate; styrene; (meth)acrylate-styrene and/or repeating units comprising a segment including urethanes; and/or combinations thereof.

Most preferably, the hydrophobic polymer backbone contains repeating units selected from alkylmethacrylates such as methylmethacrylate.

The crosslinks in the hydrophobic polymer backbone are preferably chemical and/or physical crosslinks. A physical crosslink can be formed by hydrogen bonding or Vander Waals interaction in amorphous polymer grafts or by crystalline segments in semi-crystallyne polymer grafts.

Examples of suitable monomers which provide chemical crosslinks whereby covalent bonds are formed, are e.g. divinylbenzene and ethylene glycol dimethacrylate in radical polymerisations. Multifunctional alcohols such as trimethylol propane and multifunctional isocyanates such as HDMI trimers may be used during polyurethane synthesis to provide chemical crosslinks.

Polymers which may provide physical crosslinks include for example polyurethanes prepared with semi-crystalline polyester, polyamide polyols or amorphous polyurethanes.

### Pendant hydrophobic grafts

The term "graft" in the context of the present invention refers to a side chain of a polymer which has a molecular weight of at least 350 g/mol. Such graft can be attached to a (co)polymer, for example, by (co) polymerizing monomers and/or macromers or can be obtained via post polymerization modification using reactive telomers. The hydrophobic grafts are preferably not water soluble.

The hydrophobic grafts are polymeric chains which contain repeating units preferably derived from the monomers selected from acrylates, methacrylates, acrylamides, methacrylamides, vinyl esters, vinyl ethers, styrene, styrene derivatives, and/or combinations thereof; and/or repeating units comprising a segment including tetramethylene oxide, an ester, a sulfide, a sulphone, an amide, a ketone, an imide, an imine such as propyleneimine, an urethane, an urea, a carbonate and/or combinations thereof. The repeating units derived from the monomers selected from acrylates, methacrylates, acrylamides or methacrylamides are preferably represented by the following structures: 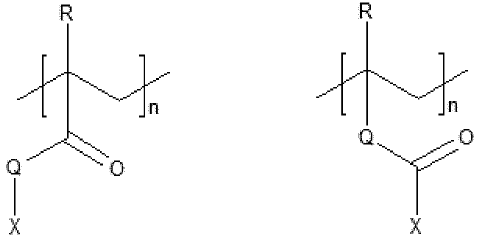 wherein
R represents hydrogen or a methyl group;
Q represents O or NH;
X represents an optionally substituted alkyl, cycloalkyl, aryl, cycloaryl, heteroaryl or cycloheteroaryl, and
n represents an integer greater than zero, preferably n represents an integer between 2 and 300, more preferably between 5 and 200, most preferably between 30 and 150.

Preferably X represents an alkyl having 1-20 carbon atoms, more preferably an alkyl having 2-10 carbon atoms and most preferably 3-8 carbon atoms.

More preferably, the hydrophobic grafts contain repeating units derived from the monomers selected from alkylacrylates wherein the alkyl group has more than one carbon atom such as for example ethylacrylate, butylacrylate, 2-ethylhexylacrylate and cyclohexylacrylate; alkyl methacrylates wherein the alkyl has more than one carbon atom such as for example ethyl methacrylate, butyl methacrylate, benzyl methacrylate, lauryl methacrylate, stearyl methacrylate and allyl methacrylate; acrylamides such as N-alkylacrylamides, methacrylamides such as N-alkylmethacrylamides, a vinyl ether such as vinyl butyl ether, a vinyl ester such as for example vinyl propionate, vinylacetate and vinyl stearate or a vinyl ester based on versatic acid; styrene; styrene derivatives such as styreneoxide; and/or combinations thereof; and/or repeating units comprising a segment including tetramethylene oxide; and/or combinations thereof.

The hydrophobic grafts even more preferably contain repeating units derived from the monomers selected from alkylacrylates wherein the alkyl group has more than three carbon atoms such as for example butylacrylate, 2-ethylhexylacrylate and cyclohexyl acrylate; alkyl methacrylates wherein the alkyl has more than three carbon atoms such as for example butyl methacrylate, benzyl methacrylate, lauryl methacrylate and stearyl methacrylate; styrene; styrene derivatives such as styreneoxide and/or combinations thereof; and/or repeating units comprising a segment including tetramethylene oxide; and/or combinations thereof.

The hydrophobic grafts most preferably contain repeating units derived from the monomers selected from alkylacrylates wherein the alkyl group has more than three carbon atoms such as for example butylacrylate, 2-ethylhexylacrylate and cyclohexyl acrylate; alkyl methacrylates wherein the alkyl has more than three carbon atoms such as for example butyl methacrylate, benzyl methacrylate, lauryl methacrylate and stearyl methacrylate and/or combinations thereof.

Preferably the hydrophobic graft contains at least 80% of at least one of these hydrophobic monomers more preferably at least 90% and most preferably at least 95%.

In order to define the hydrophobicity of the graft, the ratio of the atomic weight of the carbon atoms and the sum of the atomic weights of oxygen, sulfur and/or nitrogen atoms [C/(O+S+N)] in the repeating unit may be calculated. For example, for polybutyl acrylate grafts, the C/(O+S+N) atomic weight ratio is 84/32 = 2.63 wherein 84 = (12 g/mol x 7 C atoms) for the carbon atoms, 32 = (16 g/mol x 2 oxygen atoms) for the oxygen atoms. According to the current invention, for hydrophobic grafts including at least one repeating unit having more than one heteroatom; the C/(O+S+N) atomic weight ratio is preferably >1,4; more preferably >1,4 and < 10,0; most preferably >2,3 and < 4,0. The hydrophobic grafts preferably include substantially no (not more than 5%wt) F or Si atoms.

Highly preferred resin particles are polymethylmethacrylate particles including the hydrophobic graft, preferably alkylacrylates or alkylmethacrylates wherein the alkyl group has more than 3 carbon atoms such as for example butyl(meth)acrylates. A resin particle including a hydrophobic backbone including methylmethacrylate and hydrophobic grafts including butylacrylate is the most preferred resin particle.

The resin particles including hydrophobic polymeric grafts can be prepared by several methods. Below, as an example, suitable preparation techniques are summarized.

### a) copolymerisation of olefinic terminated macromers by radical polymerisation

Examples of olefinic terminated macromers include methacryloyl terminated polymethyl methacrylate (AA-6^{™}), methacryloyl terminated polybutylacrylate (AB-6^{™}) both available from Toagosei Co., Japan, methacryloyl terminated polybutylacrylate (MM110C^{™}) from Kaneka, and acrylate terminated polycaprolactone (Placcel FA-3^{™}) from Daicel. The use of methacrylic terminated macromers is most common.

Acrylate or methacrylate terminated macromers can be synthesized via different methods as described in various literature references, for example the synthetic method for the polyester macromers is given in Makiguchi, K. et. al., Polymer Preprints, 53(1), 2012, page 195-196; Liu Y. et al. J.M.S.-Pure Appl. Chem., A35(2), 207-232 (1998); or Yu. S., US patent 4,983,689 (1991) and the synthetic method for methacrylate-terminated poly (D,L) lactide is reported in DuBois, P. Macromolecules, 24, 977 (1991).

As an example, polyesters based macromers obtained by using hydroxyethyl maleimide (HEMI), hydroxylethyl acrylate (HEA), 4-vinylbenzyl alcohol (4-VBA) or hydroxyethyl methacrylate (HEMA) as initiator for a ring opening polymerization for lactones such as ε-caprolactone and δ-valerolactone whereby the acrylate group is positioned at the end of the macromer.

Alternatively, diols can be used as initiator for the ringopening polymerization of lactones such as for example glycerol monoacrylate or trimethylolpropane monoacrylate whereby a macromer including the reactive acrylate group along the chain is obtained. For example, the macromonomer shown below is prepared from glycerol monoacrylate and ε-caprolactone:

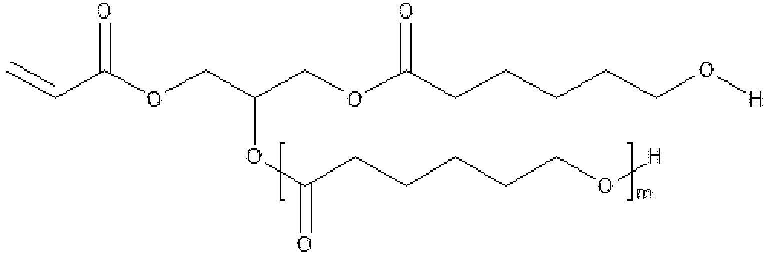

When macromers are used where the polymerisable group is located along the polymer chain, graft copolymers having double grafts may be prepared. The graft copolymer prepared e.g. by reacting butyl acrylate with the macromer prepared from trimethylolpropane monoacrylate and ε-caprolactone will contain triple grafts. Graft copolymers having mono-grafts, double grafts or multiple grafts are suitable and shown in the following scheme:

Graft copolymers with single grafts:

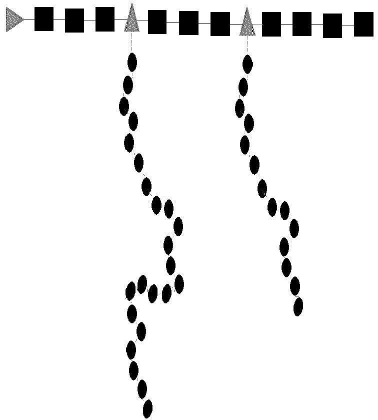

Graft copolymers with double grafts:

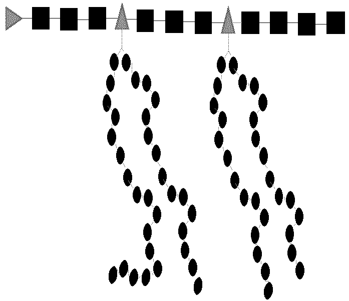

Graft copolymers with multiple (e.g. triple) grafts:

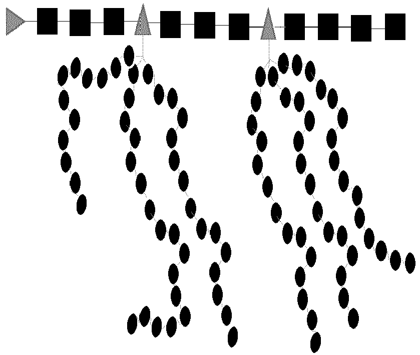

Other suitable methods for preparing polymerisable macromers are described in Schön, F. et. al., Macromolecules, 34, 5394-5397 (2001), i.e. preparation of macromers by living radical polymerization such as Atom Transfer Radical Polymerisation (ATRP). For example, a hydroxyl functional initiator can be converted to an acrylic or methacrylic group or a bromine end group can be converted to an (meth)acrylic endgroup whereby a combination of ATRP and click chemistry is employed. The endgroup is then converted to an azido endgroup and coupled with an alkyne-containing acrylate or methacrylate monomer. This method is described by Voigt A. et al., Macromolecules, 39, 5286-5292 (2006).

In the synthesis of polyurethanes one can use mono-isocyanate based monomers for endcapping, resulting in a macromer having olefinic endgroups. These macromers can then also be reacted e.g. in a mini-emulsion polymerization. For endcapping the polyurethanes and production of polyurethane based macromers one can use mono-isocyanato functional monomers like: m-Isopropenyldimethylbenzyl isocyanate = CAS registry number 2094-99-7 (Takenate TMI), 2-Acryloyloxyethyl isocyanate = CAS registry number 13641-96-8 (Karenz AOI-VM), 2-(Methacryloxy)ethyl isocyanate = CAS registry number 30674-80-7 (Karenz MOI) or mono-hydroxyfunctional monomers like hydroxyethyl maleimide (HEMI), hydroxylethyl acrylate (HEA) or hydroxyethyl methacrylate (HEMA). By copolymerization of such macromers one obtains e.g. a polyurethane graft and poly(meth)acrylic mainchain. When a PU is used with 2 methacrylic endgroups a "loop-graft" is obtained. Other examples of macromers prepared via reaction of polymerisable isocyanates at the polymer endgroup are polyimide based macromers described by Oishi T. et al., Polymer Journal, 33 (1), 81-88 (2001).

Preferably the macromonomer has only one polymerisable goup but macromers having two polymerisable groups may also be used for synthesis of the desired graft copolymers. When polymerizing such telechelic i.e. bisfunctional macromomers, a crosslinked polymer is obtained when the degree of polymerization is low; but when the telechelic macromer has a length of for example longer than 350 g/mol, then the reacted macromer may form a loop oriented graft or "loop-graft".

For example, hydrophobic dihydroxyl functional polymers can easily be converted to α,ω-bis (meth)acrylate terminated macromomers by reacting with (meth)acryloyl chloride or (meth)acrylic anhydride. Upon polymerization, such bis-(meth)acrylate functional macromomers may form a "loop-graft":

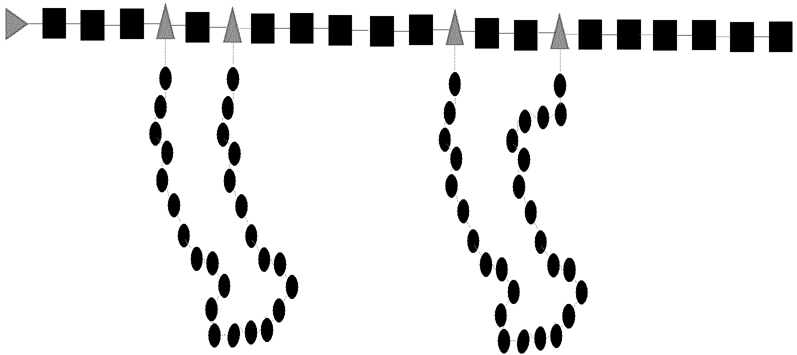

An example is e.g. dihydroxy functional polycaprolactone which can be converted to diacrylate by reaction with acryloyl chloride. When using a polyester which was initiated by DMPA, this carboxylic functional initiator can also be an advantage to orient the graft towards the outside of the particle upon preparation of e.g. a water based PU dispersion.

In order to make a graft copolymer particle using the hydrophobic macromers ((meth)acrylic, styrenic, or vinylic terminated) the most convenient technique is mini-emulsion polymerization. Using mini-emulsion, the hydrophobic macromer can be dissolved in the monomer droplet. Since a significant part of the polymer emulsion is formed by droplet nucleation, the hydrophobic macromer does not need to be transported via the water phase to the polymerization locations.

### b) copolymerisation of reactive macromers in condensation polymerization or ringopening polymerization

A convenient technique to make grafted polyurethane copolymers is via the use of diol terminated polymers which may be prepared by for example 3-mercapto-1,2-propanediol or 1-mercapto-2,3-propanediol as chain transfer agent in a radical polymerization as described by Radhakrihnan Nair, P. et al., Eur. Polym. J. 33(1), 89-95 (1997). In order to make a particle it is most convenient to make a water based dispersion. In addition to the hydrophobic grafts, hydrophilic stabilizing diols (e.g. dimethylol propionic acid (DMPA) or 1,2- and 1,3- polyether diols) or diamines may be used. A suitable hydrophilic stabilizing polyol is Ymer N120 or Tegomer D 3403, known under CAS registry number 131483-27-7, ie. α-[2,2-bis(hydroxymethyl)butyl]-ω-methoxy-poly(oxy-1,2-ethanediyl).

### c) post polymerisation modification by reacting polymers having a reactive endgroup with reactive copolymers

Graft copolymer particles may be prepared by first preparing the polymer having reactive groups - also referred to herein as reactive telomers - and then performing a post-polymerisation reaction. As an example, a polymer particle is prepared via emulsion copolymerization using glycidyl methacrylate and then a telomer having a reactive endgoup is added to the polymer particles. The synthesis of polymers with a reactive endgoup is for example described by Moad, G. et al, Polymer 46(19), 8458-8468 (2005), using living radical copolymerization using carboxy functional RAFT agents.

Another method which can be used is mini-emulsion polymerization using monomers and reactive monomers to which a hydrophobic telomer having a reactive endgroup e.g. MMA, glycidyl methacrylate and amino-terminated polybutyl acrylate is added whereby a graft copolymer is formed insitu. Alternatively, first a reactive particulate dispersion is made and subsequently the hydrophobic graft is polymerized, for example, a PU dispersion is made by using a hydroxyl functional RAFT agent followed by a seeded emulsion polymerization.

Besides the use of hydroxyfunctional chain transfer agents in polyurethane synthesis one can also use hydroxyl functional radical initiators in the polyurethane synthesis. If the chaintransfer agent has two hydroxyl groups one can make a graft copolymer, since more than one chaintransfer unit will be incorporated. After synthesis of the polyurethane in solvent and dispersion preparation, one can use the reactive PU dispersion in a free-radical polymerization. Also one can prepare first the bishydroxy terminated polymer via RAFT or ATRP and then use, this polymer in a polyurethane synthesis. This has been described by Gao Y et al in the Chinese patent CN105199050. When using this method also incorporating hydrophilic diols (such as DMPA or Ymer N120^{™}) one can make an aqueous dispersion having a polyurethane main chain and the macro-RAFT or macro-ATRP agent as graft.

The negative-working photosensitive composition may further include polymeric binders that are substantially not crosslinkable and are film-forming in nature. Such binders are preferably soluble in the coating solvent and can be selected from a wide series of organic polymers. Compositions of different binders can also be used. Useful binders are described in for example EP 1 043 627 in paragraph [0013].

### Definitions

The term "(co)polymer" in the context of the present invention refers to high molecular weight homopolymers and/or copolymers. The term "copolymer" refers to polymers that are derived from two or more different monomers. The term "backbone" in the context of the present invention refers to the chain of atoms in a polymer to which a plurality of pendant groups are attached. An example of such a backbone is an "all carbon" backbone obtained from the polymerization of an ethylenically unsaturated monomer.

The term repeating unit is a part of a polymer whose repetition can produce a polymer chain (except for the end-groups) by linking the repeating units together successively along the chain.

The term "alkyl" herein means all variants possible for each number of carbon atoms in the alkyl group i.e. methyl, ethyl, for three carbon atoms: n-propyl and isopropyl; for four carbon atoms: n-butyl, isobutyl and tertiary-butyl; for five carbon atoms: n-pentyl, 1,1-dimethyl-propyl, 2,2-dimethylpropyl and 2-methyl-butyl, etc. Examples of suitable alkyl groups are methyl, ethyl, n-propyl, isopropyl, n-butyl, 1-isobutyl, 2-isobutyl and tertiary-butyl, n-pentyl, n-hexyl, chloromethyl, trichloromethyl, iso-propyl, iso-butyl, iso-pentyl, neo-pentyl, 1-methylbutyl and iso-hexyl, 1,1-dimethyl-propyl, 2,2-dimethylpropyl and 2-methyl-butyl, cyclopropyl, cyclobutyl, cyclopentyl, cyclohexyl and methylcyclohexyl groups. Preferably, the alkyl group is a C₁ to C₆-alkyl group.

The term "aryl" herein means aryl, aralkyl, cycloaryl, heteroaryl or cycloheteroaryl. Suitable aryl groups include for example phenyl, naphthyl, benzyl, tolyl, ortho- meta- or para-xylyl, anthracenyl or phenanthrenyl. Suitable aralkyl groups include for example phenyl groups or naphthyl groups including one, two, three or more C₁ to C₆-alkyl groups. Suitable heteroaryl groups are preferably monocyclic- or polycyclic aromatic rings comprising carbon atoms and one or more heteroatoms in the ring structure. Preferably 1 to 4 heteroatoms are independently selected from nitrogen, oxygen, selenium and sulphur and/or combinations thereof. Examples include pyridyl, pyrimidyl, pyrazoyl, triazinyl, imidazolyl, (1,2,3,)- and (1,2,4)-triazolyl, tetrazolyl, furyl, thienyl, isoxazolyl, thiazolyl and carbazoyl. A cyclic group or cyclic structure includes at least one ring structure and may be a monocyclic- or polycyclic group, meaning one or more rings fused together.

Halogens are selected from fluorine, chlorine, bromine or iodine.

The term "substituted", in e.g. substituted alkyl group means that the alkyl group may be substituted by other atoms than the atoms normally present in such a group, i.e. carbon and hydrogen. For example, a substituted alkyl group may include a halogen atom or a thiol group. An unsubstituted alkyl group contains only carbon and hydrogen atoms.

Optional substituents are preferably selected from -Cl, -Br, -I, -OH, -SH, - CN, -NO₂, an alkyl group such as a methyl or ethyl group, an alkoxy group such as a methoxy or an ethoxy group, an aryloxy group, a carboxylic acid group or an alkyl ester thereof, a sulphonic acid group or an alkyl ester thereof, a phosphonic acid group or an alkyl ester thereof, a phosphoric acid group or an an ester such as an alkyl ester such as methyl ester or ethyl ester, a thioalkyl group, a thioaryl group, thioheteroaryl, -SH, a thioether such as a thioalkyl or thioaryl, ketone, aldehyde, sulfoxide, sulfone, sulfonate ester, sulphonamide, an amino, ethenyl, alkenyl, alkynyl, cycloalkyl, alkaryl, aralkyl, aryl, heteroaryl or heteroalicyclic group and/or combinations thereof.

### Other ingredients

The photopolymerisable layer may also comprise particles which increase the resistance of the coating against manual or mechanical damage. The particles may be inorganic particles, organic particles or fillers such as described in for example US 7,108,956. More details of suitable spacer particles described in EP 2 916 171 [0053] to [0056]. The thickness of spacer particles is typically higher than the coating thickness.

The photopolymerizable layer may also comprise an inhibitor. Particular inhibitors for use in the photopolymer coating are disclosed in US 6,410,205, EP 1 288 720 and EP 1 749 240.

The photopolymerizable layer may further comprise an adhesion promoting compound. The adhesion promoting compound is a compound capable of interacting with the support, preferably a compound having an addition-polymerizable ethylenically unsaturated bond and a functional group capable of interacting with the support. Under "interacting" is understood each type of physical and/or chemical reaction or process whereby, between the functional group and the support, a bond is formed which can be a covalent bond, an ionic bond, a complex bond, a coordinate bond or a hydrogen-bond, and which can be formed by an adsorption process, a chemical reaction, an acid-base reaction, a complex-forming reaction or a reaction of a chelating group or a ligand. The adhesion promoting compounds described in EP 2 916 171 [0058] are suitable examples.

Various surfactants may be added into the photopolymerisable layer to allow or enhance the developability of the precursor; especially developing with a gum solution. Both polymeric and small molecule surfactants for example nonionic surfactants are preferred. More details are described in EP 2 916 171 [0059].

Organic wax particles as described in for example US 8,679,726B and US9,063,423B which improve scratch resistance may also be added to the photopolymerisable layer.

The lithographic printing plate precursor can be prepared by (i) applying on a support the coating as described above and (ii) drying the precursor.

### Exposure step

The printing plate precursor is preferably image-wise exposed by heat and/or a laser emitting light; UV or IR light. Preferably, the image-wise exposing step is carried out off-press in a platesetter, i.e. an exposure apparatus suitable for image-wise exposing the precursor with a laser such as a laser diode, emitting around 830 nm or a Nd YAG laser emitting around 1060 nm, a violet laser, emitting around 400 nm, or a gas laser such as an Ar laser. Preferably, the precursor is image-wise exposed by a laser emitting IR-light (i.e. wavelengths ranging between 750 and 1500 nm) or violet light (i.e. wavelengths ranging between 350 and 450 nm); most preferred by a laser emitting IR-light.

Alternatively, the light source can be a bulb or lamp such as mercury vapour bulbs. The image wise exposure may be achieved by means of modulation of the light emitted from the light source. This modulation can be done by means of digital mirror devices, also called DMD imaging. UV setters which are suitable to digitally modulate the light source are available from Lüscher AG and Basysprint from Xeikon International B.V. The digital information is obtained from a digital image which is made available to the UV setter.

### Preheat step

After the exposing step, the precursor may be pre-heated in a preheating unit, preferably at a temperature of about 80°C to 150°C and preferably during a dwell time of about 5 seconds to 1 minute. This preheating unit may comprise a heating element, preferably an IR-lamp, an UV-lamp, heated air or a heated roll. Such a preheat step can be used for printing plate precursors comprising a photopolymerisable composition to enhance or to speed-up the polymerization and/or crosslinking reaction.

### Development step

Subsequently to the exposing step or the preheat step, when a preheat step is present, the plate precursor may be processed (developed). Before developing the imaged precursor, a pre-rinse step might be carried out especially for the negative-working lithographic printing precursors having a protective oxygen barrier or topcoat. This pre-rinse step can be carried out in a stand-alone apparatus or by manually rinsing the imaged precursor with water or the pre-rinse step can be carried out in a washing unit that is integrated in a processor used for developing the imaged precursor. The washing liquid is preferably water, more preferably tap water. More details concerning the wash step are described in EP 1 788 434 in [0026].

During the development step, the non-exposed areas of the image-recording layer are at least partially removed without essentially removing the exposed areas. The processing liquid, also referred to as developer, can be applied to the plate e.g. by rubbing with an impregnated pad, by dipping, immersing, coating, spincoating, spraying, pouring-on, either by hand or in an automatic processing apparatus. The treatment with a processing liquid may be combined with mechanical rubbing, e.g. by a rotating brush. During the development step, any water-soluble protective layer present is preferably also removed. The development is preferably carried out at temperatures between 20 and 40 °C in automated processing units.

In a highly preferred embodiment, the processing step as described above is replaced by an on-press processing whereby the imaged precursor is mounted on a press and processed on-press by rotating said plate cylinder while feeding dampening liquid and/or ink to the coating of the precursor to remove the unexposed areas from the support. In a preferred embodiment, only dampening liquid is supplied to the plate during start-up of the press and after a number of revolutions of the plate cylinder also the ink supply is switched on. In an alternative embodiment, supply of dampening liquid and ink is started simultaneously, or only ink can be supplied during a number of revolutions before switching on the supply of dampening liquid. After and/or during the processing step, paper can be fed to the printing press.

The processing step may also be performed by combining embodiments described above, e.g. combining development with a processing liquid with development on-press by applying ink and/or fountain.

### Processing liquid

The processing liquid may be an alkaline developer or solvent-based developer. Suitable alkaline developers have been described in US2005/0162505. An alkaline developer is an aqueous solution which has a pH of at least 8, more preferably of at least 11, more typically at least 12, most preferably from 12 to 14. Alkaline developers typically contain alkaline agents to obtain high pH values can be inorganic or organic alkaline agents. The developers can comprise anionic, non-ionic and amphoteric surfactants (up to 3% on the total composition weight); biocides (antimicrobial and/or antifungal agents), antifoaming agents or chelating agents (such as alkali gluconates), and thickening agents (water soluble or water dispersible polyhydroxy compounds such as glycerine or polyethylene glycol).

Preferably, the processing liquid is a gum solution whereby during the development step the non-exposed areas of the photopolymerisable layer are removed from the support and the plate is gummed in a single step. The development with a gum solution has the additional benefit that, due to the remaining gum on the plate in the non-exposed areas, an additional gumming step is not required to protect the surface of the support in the non-printing areas. As a result, the precursor is processed and gummed in one single step which involves a less complex developing apparatus than a developing apparatus comprising a developer tank, a rinsing section and a gumming section. The gumming section may comprise at least one gumming unit or may comprise two or more gumming units. These gumming units may have the configuration of a cascade system, i.e. the gum solution, used in the second gumming unit and present in the second tank, overflows from the second tank to the first tank when gum replenishing solution is added in the second gumming unit or when the gum solution in the second gumming unit is used once-only, i.e. only starting gum solution is used to develop the precursor in this second gumming unit by preferably a spraying or jetting technique. More details concerning such gum development is described in EP1 788 444.

A gum solution is typically an aqueous liquid which comprises one or more surface protective compounds that are capable of protecting the lithographic image of a printing plate against contamination, e.g. by oxidation, fingerprints, fats, oils or dust, or damaging, e.g. by scratches during handling of the plate. Suitable examples of such surface protective compounds are film-forming hydrophilic polymers or surfactants. The layer that remains on the plate after treatment with the gum solution preferably comprises between 0.005 and 20 g/m² of the surface protective compound, more preferably between 0.010 and 10 g/m², most preferably between 0.020 and 5 g/m². More details concerning the surface protective compounds in the gum solution can be found in WO 2007/057348 page 9 line 3 to page 11 line 6. As the developed plate precursor is developed and gummed in one step, there is no need to post-treat the processed plate.

The gum solution preferably has a pH value between 3 and 11, more preferably between 4 and 10, even more preferably between 5 and 9, and most preferably between 6 and 8. A suitable gum solution is described in for example EP 1 342 568 in [0008] to [0022] and WO2005/111727. The gum solution may further comprise an inorganic salt, an anionic surfactant, a wetting agent, a chelate compound, an antiseptic compound, an antifoaming compound and/or an ink receptivity agent and/or combinations thereof. More details about these additional ingredients are described in WO 2007/057348 page 11 line 22 to page 14 line 19.

### Drying and baking step

After the processing step the plate may be dried in a drying unit. In a preferred embodiment the plate is dried by heating the plate in the drying unit which may contain at least one heating element selected from an IR-lamp, an UV-lamp, a heated metal roller or heated air.

After drying the plate can optionally be heated in a baking unit. More details concerning the heating in a baking unit can be found in WO 2007/057348 page 44 line 26 to page 45 line 20.

The printing plate thus obtained can be used for conventional, so-called wet offset printing, in which ink and an aqueous dampening liquid is supplied to the plate. Another suitable printing method uses a so-called single-fluid ink without a dampening liquid. Suitable single-fluid inks have been described in US 4,045,232; US 4,981,517 and US 6,140,392. In a most preferred embodiment, the single-fluid ink comprises an ink phase, also called the hydrophobic or oleophilic phase, and a polyol phase as described in WO 00/32705.

### EXAMPLES

### Example 1

### Synthesis of particulate binders B-01 to B-07

The particulate binders are prepared by means of a mini-emulsion polymerization method.

### Synthesis of particulate binder B-01

In a 1 liter double jacketed reactor 54 grams of Lutensol AT50 is dissolved in 599,4 grams of demineralized water. The monomer mixture is weighted in a 250 ml Erlenmeyer, ie. 162 grams of methyl methacrylate (MMA), 9 grams of ethyleneglycol dimethacrylate (EGDMA), 9 grams of polybutylacrylate macromere Kaneka MM110C and 7,2 grams of hexadecane. Weight ratio of the monomers is 90/5/5 MMA/EGDMA/Kaneka MM110C. The monomers are mixed together with the hexadecane (added as cosurfactant to avoid droplet coalescence due to Oswalt ripening) using an magnetic stirrer. In another Erlenmeyer 1,19 grams of potassium persulfate is dissolved in 59,4 grams of water. The monomer mixture is then brought into an addition funnel with pressure equalization arm of 250 ml. An Ultraturrax homogenizer is brought into the surfactant solution which is present in the double jacketed reactor without reactor lid. The Ultraturrax is set to 11500 rotations/minute. The monomer mixture is added in about 20 minutes to the reactor. If too much foam is formed then the monomer is added a little slower. For this reaction the monomer mixture was added in 24 minutes. The Ultraturrax homogenizer is allowed to stir at high speed for another 10minutes after the addition of the monomer mixture is finished. Afterwards the reactor is closed with the reactor lid, equipped with overhead stirrer, jacketed coil condensor and flushed with nitrogen. The overhead stirrer is set to 200 RPM and the reaction mixture is heated to 75°C. The jacket temperature is set to 78 °C. When the reaction mixture has reached 75°C, we add the initiator solution immediately. The polymerization starts and due to an exothermic reaction the temperature increases to about 89,7 °C. Starting from the moment the initiator solution is added the reactor is heated for 180 minutes with a jacket temperature of 78 °C. Subsequently the residual monomer is removed by vacuum distillation, having the jacket temperature still at 78 °C and reducing the pressure to 400 mbar. The distillation is performed during 90 minutes and then the reactor is cooled to room temperature and filtered over coarse filter paper. The resulting latex has a concentration of 25,89% and a pH = 2,48. Particle size was measured using Malvern zetasizer giving a bimodal distribution, ie. 10x diluted with water 68,82 nm (79,8%) and 1480 nm (20,2%) or 10x diluted with NaCl aq (0,005M): 69,14 nm (63,1%) and 1420 nm (16,9%).

### Synthesis of particulate binder B-02

In a 1 liter double jacketed reactor 54 grams of Lutensol AT50 is dissolved in 599,4 grams of demineralized water. The monomer mixture is weighted in a 250 ml Erlenmeyer, ie. 167,4 grams of methyl methacrylate (MMA), 3,6 grams of ethyleneglycol dimethacrylate (EGDMA), 9 grams of polybutylacrylate macromere Kaneka MM110C and 7,2 grams of hexadecane. Weight ratio of the monomers is 93/2/5 MMA/EGDMA/Kaneka MM110C. The monomers are mixed together with the hexadecane (added as cosurfactant to avoid droplet coalescence due to Oswalt ripening) using a magnetic stirrer. In another Erlenmeyer 1,19 grams of potassium persulfate is dissolved in 59,4 grams of water. The monomer mixture is then brought into an addition funnel with pressure equalization arm of 250 ml. An Ultraturrax homogenizer is brought into the surfactant solution which is present in the double jacketed reactor without reactor lid. The Ultraturrax is set to 11500 rotations/minute. The monomer mixture is added in about 20 minutes to the reactor. If too much foam is formed then the monomer is added a little slower. For this reaction the monomer mixture was added in 21 minutes. The Ultraturrax homogenizer is allowed to stir at high speed for another 10minutes after the addition of the monomer mixture is finished. Afterwards the reactor is closed with the reactor lid, equipped with overhead stirrer, jacketed coil condensor and flushed with nitrogen. The overhead stirrer is set to 200 RPM and the reaction mixture is heated to 75°C. The jacket temperature is set to 78 °C. When the reaction mixture has reached 75°C, we add the initiator solution immediately. The polymerization starts and due to an exothermic reaction the temperature increases to about 91,8 °C. Starting from the moment the initiator solution is added the reactor is heated for 180 minutes with a jacket temperature of 78 °C. Subsequently the residual monomer is removed by vacuum distillation, having the jacket temperature still at 78 °C and reducing the pressure to 400 mbar. The distillation is performed during 90 minutes and then the reactor is cooled to room temperature and filtered over coarse filter paper. The resulting latex has a concentration of 26,21% and a pH = 2,48. Particle size was measured using Malvern zetasizer giving a bimodal distribution, ie. 10x diluted with water 669,37nm (79,0%) and 1233 nm (21,0%) or 10x diluted with NaCl aq (0,005M): 69,53 nm (77,8%) and 1201 nm (22,2%).

### Synthesis of particulate binder B-03

In a 1 liter double jacketed reactor 54 grams of Lutensol AT50 is dissolved in 599,4 grams of demineralized water. The monomer mixture is weighted in a 250 ml Erlenmeyer, ie. 171 grams of methyl methacrylate (MMA), 9 grams of ethyleneglycol dimethacrylate (EGDMA), and 7,2 grams of hexadecane. Weight ratio of the monomers is 95/5 MMA/EGDMA. The monomers are mixed together with the hexadecane (added as cosurfactant to avoid droplet coalescence due to Oswalt ripening) using a magnetic stirrer. In another Erlenmeyer 1,19 grams of potassium persulfate is dissolved in 59,4 grams of water. The monomer mixture is then brought into an addition funnel with pressure equalization arm of 250 ml. We bring an Ultraturrax homogenizer into the surfactant solution which is present in the double jacketed reactor without reactor lid. The Ultraturrax is set to 11500 rotations/minute. The monomer mixture is added in appr. 20 minutes to the reactor. If too much foam is formed then the monomer is added a little slower. For this reaction the monomer mixture was added in 19 minutes. The Ultraturrax homogenizer is allowed to stir at high speed for another 10minutes after the addition of the monomer mixture is finished. Afterwards the reactor is closed with the reactor lid, equipped with overhead stirrer, jacketed coil condensor and flushed with nitrogen. The overhead stirrer is set to 200 RPM and the reaction mixture is heated to 75°C. The jacket temperature is set to 78 °C. When the reaction mixture has reached 75°C, we add the initiator solution immediately. The polymerization starts and due to an exothermic reaction the temperature increases to appr. 91,9 °C. Starting from the moment the initiator solution is added the reactor is heated for 180 minutes with a jacket temperature of 78 °C. Subsequently the residual monomer is removed by vacuum distillation, having the jacket temperature still at 78 °C and reducing the pressure to 400 mbar. The distillation is performed during 90 minutes and then the reactor is cooled to room temperature and filtered over coarse filter paper. The resulting latex has a concentration of 26,04% and a pH = 2,46. Particle size was measured using Malvern zetasizer giving a monomodal distribution, ie. 10x diluted with water 86,78 nm (100%) or 10x diluted with NaCl aq (0,005M): 90,39 nm (100%).

### Synthesis of particulate binder B-04

This polymer dispersion is prepared by means of a mini-emulsion polymerization method. In a 1 liter double jacketed reactor 54 grams of Lutensol AT50 is dissolved in 599,4 grams of demineralized water. The monomer mixture is weighted in a 250 ml Erlenmeyer, ie. 162 grams of methyl methacrylate (MMA), 9 grams of ethyleneglycol dimethacrylate (EDGMA), 9 grams of AB-6 (macromer supplied by Toagosei), and 7,2 grams of hexadecane. Weight ratio of the monomers is 95/5/5 MMA/EDGMA/macromer AB-6. The monomers are mixed together with the hexadecane (added as cosurfactant to avoid droplet coalescence due to Oswalt ripening) using a magnetic stirrer. In another Erlenmeyer 1,19 grams of potassium persulfate is dissolved in 59,4 grams of water. The monomer mixture is then brought into an addition funnel with pressure equalization arm of 250 ml. We bring an Ultraturrax homogenizer into the surfactant solution which is present in the double jacketed reactor without reactor lid. The Ultraturrax is set to 11500 rotations/minute. The monomer mixture is added in appr. 20 minutes to the reactor. If too much foam is formed then the monomer is added a little slower. For this reaction the monomer mixture was added in 25 minutes. The Ultraturrax homogenizer is allowed to stir at high speed for another 10minutes after the addition of the monomer mixture is finished. Afterwards the reactor is closed with the reactor lid, equipped with overhead stirrer, jacketed coil condensor and flushed with nitrogen. The overhead stirrer is set to 200 RPM and the reaction mixture is heated to 75°C. The jacket temperature is set to 78 °C. When the reaction mixture has reached 75°C, we add the initiator solution immediately. The polymerization starts and due to an exothermic reaction the temperature increases to appr. 92,8 °C. Starting from the moment the initiator solution is added the reactor is heated for 180 minutes with a jacket temperature of 78 °C. Subsequently the residual monomer is removed by vacuum distillation, having the jacket temperature still at 78 °C and reducing the pressure to 400 mbar. The distillation is performed during 90 minutes and then the reactor is cooled to room temperature and filtered over coarse filter paper. The resulting latex has a concentration of 25,98% and a pH = 2,52. Particle size was measured using Malvern zetasizer giving a bimodal distribution, ie. 10x diluted with water 69,13 nm (82,5%) and 1411 nm (17,5%) or 10x diluted with NaCl aq (0,005M): 69,56 nm (80,2%) and 814,6 nm (19,6%).

### Synthesis of particulate binder B-05

This polymer dispersion is prepared by means of a mini-emulsion polymerization method. In a 1 liter double jacketed reactor 54 grams of Lutensol AT50 is dissolved in 599,4 grams of demineralized water. The monomer mixture is weighted in a 250 ml Erlenmeyer, ie. 167,4 grams of methyl methacrylate (MMA), 3,6 grams of ethyleneglycol dimethacrylate (EDGMA), 9 grams of AB-6 (macromer supplied by Toagosei), and 7,2 grams of hexadecane. Weight ratio of the monomers is 93/2/5 MMA/EDGMA/macromer AB-6. The monomers are mixed together with the hexadecane (added as cosurfactant to avoid droplet coalescence due to Oswalt ripening) using a magnetic stirrer. In another Erlenmeyer 1,19 grams of potassium persulfate is dissolved in 59,4 grams of water. The monomer mixture is then brought into an addition funnel with pressure equalization arm of 250 ml. We bring an Ultraturrax homogenizer into the surfactant solution which is present in the double jacketed reactor without reactor lid. The Ultraturrax is set to 11500 rotations/minute. The monomer mixture is added in appr. 20 minutes to the reactor. If too much foam is formed then the monomer is added a little slower. For this reaction the monomer mixture was added in 31 minutes. The Ultraturrax homogenizer is allowed to stir at high speed for another 10minutes after the addition of the monomer mixture is finished. Afterwards the reactor is closed with the reactor lid, equipped with overhead stirrer, jacketed coil condensor and flushed with nitrogen. The overhead stirrer is set to 200 RPM and the reaction mixture is heated to 75°C. The jacket temperature is set to 78 °C. When the reaction mixture has reached 75°C, we add the initiator solution immediately. The polymerization starts and due to an exothermic reaction the temperature increases to appr. 93,0 °C. Starting from the moment the initiator solution is added the reactor is heated for 180 minutes with a jacket temperature of 78 °C. Subsequently the residual monomer is removed by vacuum distillation, having the jacket temperature still at 78 °C and reducing the pressure to 400 mbar. The distillation is performed during 90 minutes and then the reactor is cooled to room temperature and filtered over coarse filter paper. The resulting latex has a concentration of 25,98% and a pH = 2,53. Particle size was measured using Malvern zetasizer giving a bimodal distribution, ie. 10x diluted with water 71,41 nm (86,5%) and 1878 nm (13,5%) or 10x diluted with NaCl aq (0,005M): 71,34 nm (73,1%) and 1039 nm (26,6%).

### Synthesis of particulate binder B-06

This polymer dispersion is prepared by means of a mini-emulsion polymerization method. In a 1 liter double jacketed reactor 54 grams of Lutensol AT50 is dissolved in 599,4 grams of demineralized water. The monomer mixture is weighted in a 250 ml Erlenmeyer, ie. 162,0 grams of methyl methacrylate (MMA), 9 grams of ethyleneglycol dimethacrylate (EDGMA), 9 grams of AA-6 (macromer supplied by Toagosei), and 7,2 grams of hexadecane. Weight ratio of the monomers is 90/5/5 MMA/EDGMA/macromer AA-6. The monomers are mixed together with the hexadecane (added as cosurfactant to avoid droplet coalescence due to Oswalt ripening) using a magnetic stirrer. In another Erlenmeyer 1,19 grams of potassium persulfate is dissolved in 59,4 grams of water. The monomer mixture is then brought into an addition funnel with pressure equalization arm of 250 ml. We bring an Ultraturrax homogenizer into the surfactant solution which is present in the double jacketed reactor without reactor lid. The Ultraturrax is set to 11500 rotations/minute. The monomer mixture is added in appr. 20 minutes to the reactor. If too much foam is formed then the monomer is added a little slower. For this reaction the monomer mixture was added in 17 minutes. The Ultraturrax homogenizer is allowed to stir at high speed for another 10minutes after the addition of the monomer mixture is finished. Afterwards the reactor is closed with the reactor lid, equipped with overhead stirrer, jacketed coil condensor and flushed with nitrogen. The overhead stirrer is set to 200 RPM and the reaction mixture is heated to 75°C. The jacket temperature is set to 78 °C. When the reaction mixture has reached 75°C, we add the initiator solution immediately. The polymerization starts and due to an exothermic reaction the temperature increases to appr. 92,6 °C. Starting from the moment the initiator solution is added the reactor is heated for 180 minutes with a jacket temperature of 78 °C. Subsequently the residual monomer is removed by vacuum distillation, having the jacket temperature still at 78 °C and reducing the pressure to 400 mbar. The distillation is performed during 90 minutes and then the reactor is cooled to room temperature and filtered over coarse filter paper. The resulting latex has a concentration of 25,57% and a pH = 2,22. Particle size was measured using Malvern zetasizer giving a bimodal distribution, ie. 10x diluted with water 71,95 nm (76,8%) and 1158 nm (21,2%) or 10x diluted with NaCl aq (0,005M): 71,13 nm (76,5%) and 1055 nm (23,5%).

### Synthesis of particulate binder B-07

This polymer dispersion is prepared by means of a mini-emulsion polymerization method. In a 1 liter double jacketed reactor 54 grams of Lutensol AT50 is dissolved in 599,4 grams of demineralized water. The monomer mixture is weighted in a 250 ml Erlenmeyer, ie. 167,4 grams of methyl methacrylate (MMA), 3,6 grams of ethyleneglycol dimethacrylate (EDGMA), 9 grams of AA-6 (macromer supplied by Toagosei), and 7,2 grams of hexadecane. Weight ratio of the monomers is 93/2/5 MMA/EDGMA/macromer AA-6. The monomers are mixed together with the hexadecane (added as cosurfactant to avoid droplet coalescence due to Oswalt ripening) using a magnetic stirrer. In another Erlenmeyer 1,19 grams of potassium persulfate is dissolved in 59,4 grams of water. The monomer mixture is then brought into an addition funnel with pressure equalization arm of 250 ml. We bring an Ultraturrax homogenizer into the surfactant solution which is present in the double jacketed reactor without reactor lid. The Ultraturrax is set to 11500 rotations/minute. The monomer mixture is added in appr. 20 minutes to the reactor. If too much foam is formed then the monomer is added a little slower. For this reaction the monomer mixture was added in 29 minutes. The Ultraturrax homogenizer is allowed to stir at high speed for another 10minutes after the addition of the monomer mixture is finished. Afterwards the reactor is closed with the reactor lid, equipped with overhead stirrer, jacketed coil condensor and flushed with nitrogen. The overhead stirrer is set to 200 RPM and the reaction mixture is heated to 75°C. The jacket temperature is set to 78 °C. When the reaction mixture has reached 75°C, we add the initiator solution immediately. The polymerization starts and due to an exothermic reaction the temperature increases to appr. 92,4 °C. Starting from the moment the initiator solution is added the reactor is heated for 180 minutes with a jacket temperature of 78 °C. Subsequently the residual monomer is removed by vacuum distillation, having the jacket temperature still at 78 °C and reducing the pressure to 400 mbar. The distillation is performed during 90 minutes and then the reactor is cooled to room temperature and filtered over coarse filter paper. The resulting latex has a concentration of 25,34% and a pH = 2,26. Particle size was measured using Malvern zetasizer giving a bimodal distribution, ie. 10x diluted with water 73,77 nm (82,4%) and 1237 nm (17,4%) or 10x diluted with NaCl aq (0,005M): 71,25 nm (76,5%) and 1030 nm (23,5%).

### Preparation of the printing plate precursors

### Preparation of the aluminium support S-01

A 0.3 mm thick aluminium foil was degreased by spraying with an aqueous solution containing 26 g/l NaOH at 65°C for 2 seconds and rinsed with demineralised water for 1.5 seconds. The foil was then electrochemically grained during 10 seconds using an alternating current in an aqueous solution containing 15 g/l HCl, 15 g/l SO42- ions and 5 g/l Al3+ ions at a temperature of 37°C and a current density of about 100 A/dm2. Afterwards, the aluminium foil was then desmutted by etching with an aqueous solution containing 5.5 g/l of NaOH at 36°C for 2 seconds and rinsed with demineralised water for 2 seconds. The foil was subsequently subjected to anodic oxidation during 15 seconds in an aqueous solution containing 145 g/l of sulfuric acid at a temperature of 50°C and a current density of 17 A/dm2, then washed with demineralised water for 11 seconds and dried at 120°C for 5 seconds.

The support thus obtained was characterized by a surface roughness Ra of 0.35-0.4 µm (measured with interferometer NT1100) and had an oxide weight of 3.0 g/m².

### Preparation of inventive printing plates PPP-01 to PPP-7 and comparative printing plate PPP-8

### Photopolymerisable layer

The photosensitive layers PL-01 to PL-08 as defined in Table 1 were coated onto the above described support S-01. The components were dissolved in a mixture of 35% by volume of MEK and 65% by volume of Dowanol PM (1-methoxy-2-propanol, commercially available from DOW CHEMICAL Company). The coating solution was applied at a wet coating thickness of 30 µm and then dried at 120°C for 2 minutes in a circulation oven.

**Table 1: Composition of the photosensitive layer**

| **INGR** | **PL-01** | **PL-02** | **PL-03** | **PL-04** | **PL-05** | **PL-06** | **PL-07** | **PL-08** |
|---|---|---|---|---|---|---|---|---|
| g/m² | | | | | | | | |
| FST 510 (1) | 0.384 | 0.384 | 0.384 | 0.384 | 0.384 | 0.384 | 0.384 | 0.384 |
| Tegoglide 410 (2) | 0.002 | 0.002 | 0.002 | 0.002 | 0.002 | 0.002 | 0.002 | 0.002 |
| Initiator-01 (3) | 0.078 | 0.078 | 0.078 | 0.078 | 0.078 | 0.078 | 0.078 | 0.078 |
| Adagio (4) | 0.028 | 0.028 | 0.028 | 0.028 | 0.028 | 0.028 | 0.028 | 0.028 |
| CN UVE 151 (5) | 0.365 | 0.365 | 0.365 | 0.365 | 0.365 | 0.365 | 0.365 | 0.365 |
| Albritect CP 30 (6) | 0.031 | 0.031 | 0.031 | 0.031 | 0.031 | 0.031 | 0.031 | 0.031 |
| Sipomer PAM 100 (7) | 0.169 | 0.169 | 0.169 | 0.169 | 0.169 | 0.169 | 0.169 | 0.169 |
| Disperbyk 182 (8) | 0.078 | 0.078 | 0.078 | 0.078 | 0.078 | 0.078 | 0.078 | 0.078 |
| Yamamoto red 40 (9) | 0.066 | 0.066 | 0.066 | 0.066 | 0.066 | 0.066 | 0.066 | 0.066 |
| Sodiumtetraphenylborate (10) | 0.020 | 0.020 | 0.020 | 0.020 | 0.020 | 0.020 | 0.020 | 0.020 |
| Particulate binder 1 (11) | 0.208 | | | | | | | |
| Particulate binder 2 (11) | | 0.208 | | | | | | |
| Particulate binder 3 (11) | | | 0.208 | | | | | |
| Particulate binder 5 (11) | | | | 0.208 | | | | |
| Particulate binder 6 (11) | | | | | 0.208 | | | |
| Particulate binder 7 (11) | | | | | | 0.208 | | |
| Particulate binder 8 (11) | | | | | | | 0.208 | |
| S-LEC BXL (12) | | | | | | | | 0.208 |

| | | | | | | | | |
|---|---|---|---|---|---|---|---|---|
| 1) FST 510 is a reaction product from 1 mole of 2,2,4-trimethylhexamethylenediisocyanate and 2 moles of hydroxyethyl-methacrylate commercially available from AZ Electronics as a 82 wt.% solution in MEK; 2) Tegoglide 410 is a surfactant commercially available from Evonik Tego Chemie GmbH; 3) Initiator-01 is tribromomethylphenolsulfon; 4) Adagio is an IR dye commercially available from FEW chemicals; 5) CN UVE 151 is an epoxyacrylate oligomer commercially available from Sartomer; 6) Albritect CP 30, is a copolymer of vinylphosphonic acid and acrylic acid commercially available as a 20wt.% aqueous dispersion from Rhodia; 7) Sipomer PAM 100 is a methacrylate phosphate ester commercially available from Rhodia; 8) Disperbyk 182 is a surfactant commercially available as a 43 wt.% solution from Byk Chemie GmbH; 9) Yamamoto Red 40 is a leuco dye commercially available from Mitsui Chemicals Europe GmbH; 10) Sodiumtetraphenyl borate is commercially available from Merck; 11) Particulate binder is prepared as described above; 12) S-LEC BXL, a polyvinylbutyral commercially available from Sekisui. | | | | | | | | |

### Protective Top layer

On top of the photosensitive layer, a solution in water with the composition as defined in Table 2 was coated (20 µm) on the photosensitive layer, and dried at 120°C for 2 minutes. Inventive printing plate precursors PPP-01, PPP-02, PPP-04 to PPP-07 and comparative printing plate precursors PPP-03 and PPP-08 were obtained.

**Table 2: Composition of the overcoat.**

| **Ingredients** | **OC-01** |
|---|---|
| g/m² | |
| Mowiol 4/88 (1) | 0.367 |
| Mowiol 8/88 (1) | 0.113 |
| Luvitec K30 (2) | 0.115 |
| Lutensol A8 (3) | 0.011 |

| | |
|---|---|
| 1) Mowiol 4-88 and Mowiol 8-88TM are partially hydrolyzed polyvinylalcohols, both commercially available from Kuraray; 2) Luvitec K30 is a polyvinylpyrrolidone commercially available from BASF. 3) Lutensol A8 is a surface active agent commercially available from BASF. | |

**Table 3: Printing plate precursors PPP-01 to PPP-08**

| **Printing plate precursor** | **Overcoat** | **Photolayer** |
|---|---|---|
| PPP-01, *inventive* | OC-01 | PL-01 |
| PPP-02, *inventive* | OC-01 | PL-02 |
| PPP-03, *comparative* | OC-01 | PL-03 |
| PPP-04, *inventive* | OC-01 | PL-04 |
| PPP-05, *inventive* | OC-01 | PL-05 |
| PPP-06, *inventive* | OC-01 | PL-06 |
| PPP-07, *inventive* | OC-01 | PL-07 |
| PPP-08, *comparative* | OC-01 | PL-08 |

### Imaging

The printing plate precursors PPP-01 to PPP-08 were imaged at 2400 dpi with a High Power Creo 40W TE38 thermal platesetter^{™} (200 Ipi Agfa Balanced Screening (ABS)), commercially available from Kodak and equipped with a 830 nm IR laser diode, at an energy densitie of 80 mJ/cm².

### On-press development

After imaging, the printing plate precursors PPP-01 to PPP-08 were put on press for on press development. The plates were printed on a GTO52 Dahlgren sheetfed press and the amount of pages needed before background and image were toning-free (on press clean-out) were assessed. Each print job was started using K+E Novavit 800 Skinnex ink (trademark of BASF Druckfarben GmbH) and 4 wt% Prima FS404 (trademark of Agfa Graphics) in water as fountain solution. A compressible blanket was used and printing was performed on non-coated offset paper. The press was start-up in such a way that first fountain was supplied to the printing plate precursor for 10 revolutions, then ink was supplied for 5 revolutions, and then paper contact was started.

### Results

### Cleanout behaviour

The amount of pages needed to clean-out the printing plate precursors was assessed. This clean-out is characterized by the full removal of the coating in non-imaged areas resulting in toning-free printing of these non-imaged parts.

The amount of pages required to reach clean-out should be as low as possible and, in accordance with the present invention, at most 25 sheets, preferably at most 15 sheets. The cleanout values obtained for the printing plates PP-01 to PP-08 are given in Table 4.

The printing plates PP-01 to PP-07 demonstrate that the printing plates including discrete resin particles (comparative PP-03) and the printing plates including discrete resin particles including pendant hydrophobic grafts (inventive PP-01, PP-02 and PP-04 to PP-07), exhibit an improved cleanout performance (15 sheets) in comparison with the comparative printing plate PP-08 including a film forming binder which exhibits an unacceptable cleanout performance (100 sheets).

**Table 4: Results of cleanout behaviour**

| **Printing plate precursor** | **Clean-out achieved at page** |
|---|---|
| PPP-01 Inventive | 15 |
| PPP-02 Inventive | 15 |
| PPP-03 Comparative | 15 |
| PPP-04 Inventive | 15 |
| PPP-05 Inventive | 15 |
| PPP-06 Inventive | 15 |
| PPP-07 Inventive | 15 |
| PPP-08 Comparative | 100 |

### Ink acceptance

The print result of the printing plates PP-01 to PP-08 was assessed by evaluating the ink density on the printed sheets of the image areas after 30 impressions. The number of printed sheets with an insufficient ink density in the printing areas should be is as low as possible. The results of the ink acceptance evaluation are given in Table 5.

**Table 5: Results of ink acceptance**

| **Printing plate** | **Ink density of the image areas after 30 impressions*** |
|---|---|
| PP-0, *inventive* | +++ |
| PP-02, *inventive* | +++ |
| PP-03, *comparative* | - |
| PP-04, *inventive* | +++ |
| PP-05, *inventive* | +++ |
| PP-06, *inventive* | + |
| PP-07, *inventive* | + |
| PP-08, *comparative* | No clean out |

| | |
|---|---|
| No clean out is obtained for the printing plate including a film-forming binder (PP-08). The results in Table 5 further show that a particulate binder comprising no grafts (PP-03) has a low ink density after 30 impressions and a particulate binder comprising grafts of the same material as the particulate binder itself (PP-06, PP-07) causes a lower ink acceptance compared to particulate binders comprising longer grafts (PP-01, PP-02, PP-04 and PP-05). *A quotation of the ink density is given by visual inspection of the plate; a score of 1 or 2 is given for the degree to which the image areas are covered with ink: +++ = image totally covered by ink; + = image covered by ink for about 80%; - = image covered by ink for only about 60% or less. | |

## Claims

1. A lithographic printing plate precursor including a support and a coating comprising a polymerisable compound, a photoinitiator, optionally a sensitizer and a polymeric binder, said binder being present, at least partially, as discrete particles,
**characterized in that** the discrete particles comprise a crosslinked hydrophobic polymer backbone and a plurality of hydrophobic pendant grafts.

2. A printing plate precursor according to claim 1 wherein the hydrophobic pendant grafts contain repeating units derived from the monomers selected from acrylates, methacrylates, acrylamides, methacrylamides, vinyl esters, vinyl ethers, styrene, styrene derivatives, and/or combinations thereof; and/or repeating units comprising a segment including tetramethylene oxide, an ester, a ketone, a sulfide, a sulphone, an amide, an imide, an imine, an urethane, an urea, a carbonate and/or combinations thereof.

3. A printing plate precursor according to claims 1 or 2 wherein the repeating units derived from acrylates, methacrylates, acrylamides or methacrylamides are represented by the following structures: 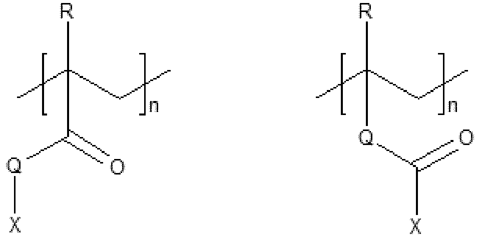 wherein
R represents hydrogen or a methyl group;
Q represents O or NH;
X represents an optionally substituted alkyl, cycloalkyl, aryl, cycloaryl, heteroaryl or cycloheteroaryl, and
n represents an integer greater than zero.

4. A precursor according to any of the preceding claims wherein the hydrophobic grafts include at least one repeating unit having more than one heteroatom and wherein the ratio of the atomic weight of the carbon atoms and the sum of the atomic weights of oxygen, sulfur and/or nitrogen [C/(O+S+N)] in the repeating unit is >1,4 and < 10,0.

5. A precursor according to any of the preceding claims wherein the size of the discrete particles is smaller than the thickness of the coating.

6. A precursor according to any of the preceding claims wherein the hydrophobic polymer backbone contains repeating units derived from the monomers selected from alkyl(meth)acrylates, styrene, (meth)acrylatestyrene, vinylchlorides, vinylidene chlorides, vinyl esters, vinyl ethers, and/or vinylidene fluorides, and/or combinations thereof, and/or repeating units comprising a segment including ethers, esters, amides, ketones, carbonates, olefines, halogenated olefines, imides, urethanes and/or a polyurea and/or combinations thereof.

7. A precursor according to any of the preceding claims wherein the coating is capable of being developed on-press with dampening liquid and/or ink.

8. A method for making a lithographic printing plate precursor including the steps of
- applying on a support a coating including a photopolymerisable layer as defined in claims 1 to 7; and
- drying the precursor.

9. A method for making a printing plate including the steps of
- image-wise exposing the printing plate precursor according to claims 1 to 7 to heat and/or light;
- developing the precursor.

## Patentansprüche

1. Ein Vorläufer einer lithografischen Druckplatte, umfassend einen Träger und eine Beschichtung, die eine polymerisierbare Verbindung, einen Fotoinitiator, gegebenenfalls einen Sensibilisator und ein polymeres Bindemittel enthält, wobei das Bindemittel mindestens teilweise in Form diskreter Partikel enthalten ist, **dadurch gekennzeichnet, dass** die diskreten Partikel eine vernetzte hydrophobe Polymerhauptkette und eine Vielzahl hydrophober Seitenpfröpfe enthalten.

2. Ein Druckplattenvorläufer nach Anspruch 1, wobei die hydrophoben Seitenpfröpfe Wiederholeinheiten enthalten, abgeleitet von den Monomeren, die aus Acrylaten, Methacrylaten, Acrylamiden, Methacrylamiden, Vinylestern, Vinylethern, Styrol, Styrol-Derivaten und/oder Kombinationen derselben ausgewählt werden, und/oder Wiederholeinheiten, enthaltend ein Segment, enthaltend Tetramethylenoxid, einen Ester, ein Keton, ein Sulfid, ein Sulfon, ein Amid, ein Imid, ein Imin, ein Urethan, einen Harnstoff, ein Carbonat und/oder Kombinationen derselben.

3. Ein Druckplattenvorläufer nach den Ansprüchen 1 oder 2, wobei die von Acrylaten, Methacrylaten, Acrylamiden oder Methacrylamiden abgeleiteten Wiederholeinheiten den folgenden Strukturen entsprechen: 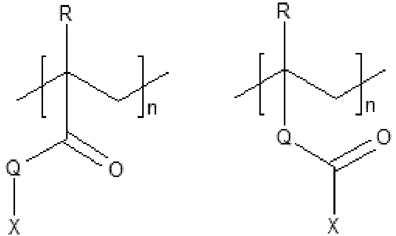 in denen
R Wasserstoff oder eine Methylgruppe bedeutet,
Q O oder NH bedeutet,
X eine gegebenenfalls substituierte Alkylgruppe, Cycloalkylgruppe, Arylgruppe, Cycloarylgruppe, Heteroarylgruppe oder Cycloheteroarylgruppe bedeutet, und
n eine ganze Zahl von mehr als 0 bedeutet.

4. Ein Vorläufer nach einem der vorstehenden Ansprüche, wobei die hydrophoben Pfröpfe mindestens eine Wiederholeinheit, die mehr als ein Heteroatom enthält, enthalten und wobei das Verhältnis des Atomgewichts der Kohlenstoffatome und der Summe der Atomgewichte von Sauerstoff, Schwefel und/oder Stickstoff [C/(O+S+N)] in der Wiederholeinheit > 1,4 und < 10,0 beträgt.

5. Ein Vorläufer nach einem der vorstehenden Ansprüche, wobei die Größe der diskreten Partikel unterhalb der Beschichtungsstärke liegt.

6. Ein Vorläufer nach einem der vorstehenden Ansprüche, wobei die hydrophobe Polymerhauptkette Wiederholeinheiten enthält, abgeleitet von den Monomeren, ausgewählt aus Alkyl(meth)acrylaten, Styrol, (Meth)acrylatstyrol, Vinylchloriden, Vinylidenchloriden, Vinylestern, Vinylethern und/oder Vinylidenfluoriden und/oder Kombinationen derselben, und/oder Wiederholeinheiten, enthaltend ein Segment, das Ether, Ester, Amide, Ketone, Carbonate, Olefine, halogenierte Olefine, Imide, Urethane und/oder einen Polyharnstoff und/oder Kombinationen derselben enthält.

7. Ein Vorläufer nach einem der vorstehenden Ansprüche, wobei die Beschichtung auf der Presse mit Feuchtwasser und/oder Tinte entwickelt werden kann.

8. Ein Verfahren zur Herstellung eines Vorläufers einer lithografischen Druckplatte, umfassend die folgenden Schritte:
- Auftrag auf einen Träger einer Beschichtung, die eine wie in den Ansprüchen 1 bis 7 definierte fotopolymerisierbare Schicht umfasst, und
- Trocknung des Vorläufers.

9. Ein Verfahren zur Herstellung einer Druckplatte, umfassend die folgenden Schritte:
- bildweise Erwärmung und/oder Belichtung des Druckplattenvorläufers nach den Ansprüchen 1 bis 7,
- Entwicklung des Vorläufers.

## Revendications

1. Précurseur de plaque d'impression lithographique comprenant un support et un revêtement comprenant un composé polymérisable, un photo-initiateur, éventuellement un sensibilisateur et un liant polymère, ledit liant étant présent au moins partiellement sous forme de particules distinctes, **caractérisé en ce que** les particules distinctes comprennent un squelette polymère hydrophobe réticulé et une multitude de chaînes latérales hydrophobes.

2. Précurseur de plaque d'impression selon la revendication 1, **caractérisé en ce que** les chaînes latérales hydrophobes contiennent des motifs de répétition dérivés des monomères sélectionnés parmi des acrylates, des méthacrylates, des acrylamides, des méthacrylamides, des esters vinyliques, des éthers vinyliques, du styrène, des dérivés de styrène et/ou des combinaisons de ceux-ci et/ou des motifs de répétition comprenant un segment contenant de l'oxyde de tétraméthylène, un ester, une cétone, un sulfure, une sulfone, un amide, un imide, une imine, un uréthane, une urée, un carbonate et/ou des combinaisons de ceux-ci.

3. Précurseur de plaque d'impression selon les revendications 1 ou 2, **caractérisé en ce que** les motifs de répétition dérivés d'acrylates, de méthacrylates, d'acrylamides ou de méthacrylamides répondent aux structures suivantes: 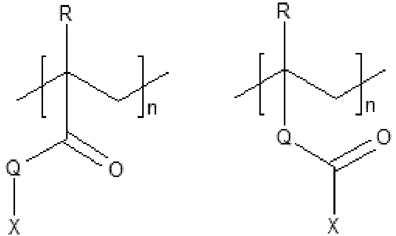 où
R représente l'hydrogène ou un groupe méthyle,
Q représente O ou NH,
X représente un groupe alkyle éventuellement substitué, un groupe cycloalkyle éventuellement substitué, un groupe aryle éventuellement substitué, un groupe cycloaryle éventuellement substitué, un groupe hétéroaryle éventuellement substitué ou un groupe cyclohétéroaryle éventuellement substitué, et
n représente un nombre entier supérieur à 0.

4. Précurseur selon l'une quelconque des revendications précédentes, **caractérisé en ce que** les chaînes latérales hydrophobes contiennent au moins un motif de répétition contenant plus d'un hétéroatome et que le rapport du poids atomique des atomes de carbone et de la somme des poids atomiques des atomes d'oxygène, de soufre et/ou d'azote [C/(O+S+N)] dans le motif de répétition s'élève à > 1,4 et < 10,0.

5. Précurseur selon l'une quelconque des revendications précédentes, **caractérisé en ce que** la taille des particules distinctes est inférieure à l'épaisseur du revêtement.

6. Précurseur selon l'une quelconque des revendications précédentes, **caractérisé en ce que** le squelette polymère hydrophobe comprend des motifs de répétition dérivés des monomères sélectionnés parmi des (méth)acrylates d'alkyle, du styrène, du styrène de (méth)acrylate, des chlorures de vinyle, des chlorures de vinylidène, des esters vinyliques, des éthers vinyliques et/ou des fluorures de vinylidène et/ou des combinaisons de ceux-ci et/ou des motifs de répétition comprenant un segment contenant des éthers, des esters, des amides, des cétones, des carbonates, des oléfines, des oléfines halogénées, des imides, des uréthanes et/ou une polyurée et/ou des combinaisons de ceux-ci.

7. Précurseur selon l'une quelconque des revendications précédentes, **caractérisé en ce que** le revêtement peut être développé sur la presse en utilisant une solution de mouillage et/ou de l'encre.

8. Procédé pour la fabrication d'un précurseur de plaque d'impression lithographique comprenant les étapes consistant à:
- appliquer sur un support un revêtement comprenant une couche photopolymérisable telle que définie selon les revendications 1 à 7, et
- sécher le précurseur.

9. Procédé pour la fabrication d'une plaque d'impression comprenant les étapes consistant à:
- exposer sous forme d'image à de la chaleur et/ou à de la lumière le précurseur de plaque d'impression selon les revendications 1 à 7,
- développer le précurseur.
